# EUROPEAN PATENT SPECIFICATION

(11) **EP 3 392 911 B1**
(45) Date of publication and mention of the grant of the patent: **21.04.2021**
(21) Application number: 16874744.2
(22) Date of filing: 02.12.2016
(51) Int. Cl.: H01L 27/32, H01L 51/54, H01L 51/52

(54) **ORGANIC LIGHT-EMITTING DISPLAY DEVICE AND DISPLAY APPARATUS**
ORGANISCHE LICHTEMITTIERENDE ANZEIGEVORRICHTUNG UND ANZEIGEVORRICHTUNG
DISPOSITIF D'AFFICHAGE ÉLECTROLUMINESCENT ORGANIQUE ET APPAREIL D'AFFICHAGE

(30) Priority: 15.12.2015 CN 201510937461
(43) Date of publication of application: 24.10.2018
(73) Proprietor: Kunshan New Flat Panel Display Technology Center Co. Ltd, KunShan, Jiangsu 215300 (CN); Kunshan Go-Visionox Opto-Electronics Co., Ltd., KunShan City, Jiangsu 215300 (CN)
(72) Inventor: LI, Weiwei, Kunshan, Jiangsu 215300 (CN); LIU, Song, Kunshan, Jiangsu 215300 (CN); XIE, Jing, Kunshan, Jiangsu 215300 (CN); MIN, Chao, Kunshan, Jiangsu 215300 (CN); ZHAO, Fei, Kunshan, Jiangsu 215300 (CN); GAO, Song, Kunshan, Jiangsu 215300 (CN)
(74) Representative: Arnold & Siedsma
(86) International application number: PCT/CN2016/108389
(87) International publication number: WO 2017/101687

(56) References cited:
- EP-A1- 2 502 908
- CN-A- 104 505 464
- CN-A- 104 659 268
- CN-A- 104 835 916
- CN-A- 104 835 916
- US-A1- 2004 209 115
- US-A1- 2015 166 886
- US-A1- 2015 280 158
- US-A1- 2015 351 168
- SEOK JAE LEE ET AL: "A Study on the Phosphorescent Blue Organic Light-Emitting Diodes Using Various Host Materials", MOLECULAR CRYSTALS AND LIQUID CRYSTALS, vol. 507, no. 1, 3 September 2009 (2009-09-03), pages 345-352, XP055518616, UK ISSN: 1542-1406, DOI: 10.1080/15421400903054287
- JIE LI ET AL: "Highly Efficient Organic Light-Emitting Diode Based on a Hidden Thermally Activated Delayed Fluorescence Channel in a Heptazine Derivative", ADVANCED MATERIALS, vol. 25, no. 24, 25 June 2013 (2013-06-25) , pages 3319-3323, XP055224309, DE ISSN: 0935-9648, DOI: 10.1002/adma.201300575

## Description

### FIELD

The present disclosure relates to the field of flat panel display technology, especially to an organic light-emitting display and a display device.

### BACKGROUND

At present, an organic light-emitting display (OLED) is divided into a single host OLED and a dual host OLED, wherein the single host OLED has the problem of low current efficiency and short service life, while the dual host OLED is more beneficial to the carrier balance adjustment and has better performance compared with the single host OLED. However, the dual host OLED requires high process stability. A slight ratio variation of two host materials of the dual host OLED would cause great change of OLED performance, which is a big challenge to product yield on production line.

### SUMMARY

Based on the above, to resolve the problem of low current efficiency and short service life of the conventional single host OLED, an organic light-emitting display with high current efficiency and long service life is provided.

An organic light-emitting display includes:
a first electrode;
a second electrode; and
a functional structure layer located between the first electrode and the second electrode, wherein the functional structure layer includes a hole injection layer, a first hole transport layer, a second hole transport layer, an organic light-emitting layer, an electron transport layer, and an electron injection layer which are sequentially laminated on the first electrode,
wherein a highest occupied orbital energy level of a first material forming the first hole transport layer is less than a highest occupied orbital energy level of a second material forming the second hole transport layer; a triplet state energy level of the second material is greater than 2.5eV;
the organic light-emitting layer includes a light-emitting material, the light-emitting material includes a thermal activation delay fluorescent material.

Furthermore, the second material forming the second hole transport layer is selected from a compound represented by a structural formula (1) below 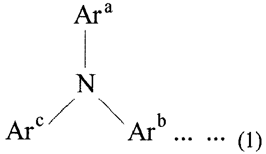 wherein
-Ar^{a} is represented by a structural formula (1-1) or (1-2) below,

   - L^{a}-(-Ar^{d})_{n ......} ₍₁₋₁₎

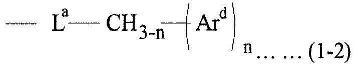

   where -L^{a} is selected from aromatic ring containing 6 to 25 ring carbon atoms, or aromatic heterocyclic ring containing 5 to 25 ring atoms, -Ar^{d} is selected from aryl group containing 6 to 25 ring carbon atoms, or heteroaryl group containing 5 to 25 ring atoms, n is selected from 2 or 3, and a plurality of -Ar^{d} are same or different;
-Ar^{b} is represented by a structural formula (1-3) below 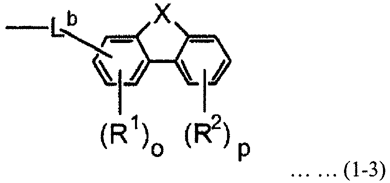
   where -L^{b} is selected from an arylene group containing 6 to 25 ring carbon atoms, or heteroarylene group containing 5 to 25 ring atoms; L^{b} is connected to a ring connecting with R¹ by a single bond,
   R¹ and R² are each independently selected from alkyl group containing 1 to 15 carbon atoms, alkenyl group containing 2 to 15 carbon atoms, naphthenic group containing 3 to 15 ring carbon atoms, aryl group containing 6 to 25 ring carbon atoms, heteroaryl group containing 5 to 25 ring atoms, trialkylsilyl group formed by alkyl groups each containing 1 to 15 carbon atoms, triarylsilyl group formed by aryl groups each containing 6 to 25 ring carbon atoms, alkylarylsilyl group formed by alkyl group containing 1 to 15 carbon atoms and aryl group containing 6 to 25 ring carbon atoms, carbazolyl group, halogen atom, or cyano group, o is selected from an integer of 0 to 3, p is selected from an integer of 0 to 4, a plurality of R¹ adjacent to each other are bondable to each other to form a ring, a plurality of R² adjacent to each other are bondable to each other to form a ring, R¹ and R² are bondable to each other to form a ring, X is selected from CR³R⁴, NR⁵, O or S, and R³, R⁴, and R⁵ each are independently selected from an alkyl group containing 1 to 15 carbon atoms, or aryl group containing 6 to 25 ring carbon atoms; and
   Ar^{c} is selected from aryl group containing 6 to 50 ring carbon atoms or heteroaryl group containing 5 to 25 ring atoms, or a structure represented by the structural formula (1-1), (1-2), or (1-3).

The thickness of the second hole transport layer is 20-50 nm.

In one embodiment, a thickness of the second hole transport layer is 35-45 nm.

In one embodiment, the light emitting host material include a green light thermal activation delay fluorescent material.

In one embodiment, the light emitting host material is selected from a compound represented by a structural formula (2) below 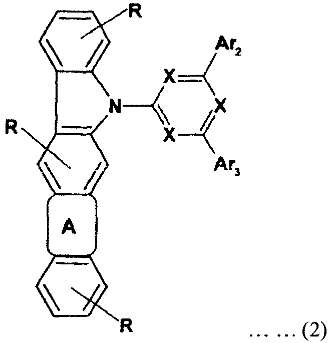 wherein
a ring A is represented by a structural formula (2-1) below 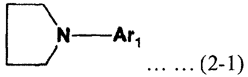 the ring A and a ring adjacent to the ring A form a condensed ring; X is selected from N or CH, and at least one X is selected from N; Ar₁, Ar₂, and Ar₃ are each independently selected from non-condensed ring aryl hydrocarbon substituent, or non-condensed ring aryl heterocyclic substituent, and it is not ruled out that Ar₂ and Ar₃ form a condensed ring structure through an aromatic ring containing heteroatom; and R is selected from H atom or monovalent substituent.

In one embodiment, the light emitting host material is selected from one of compounds represented by the following structural formulas (3-1), (3-2) and (3-3): 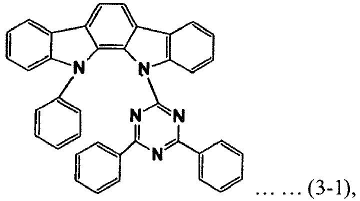 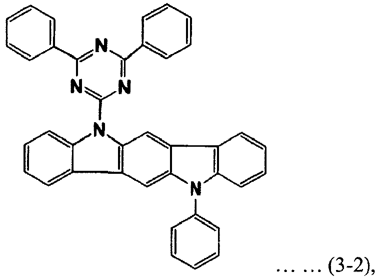 and

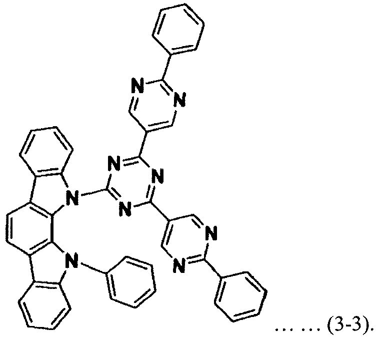

In one embodiment, the light emitting host material comprises a red light thermal activation delay fluorescent material.

In one embodiment, a thickness of the first hole transport layer is 1-40 nm.

A display device including the above organic light-emitting display is further provided in the present disclosure.

Compared with the prior art, the organic light-emitting display in the present disclosure adopts two hole transport layers, wherein the second hole transport layer acts as an electron blocking layer and an optical compensation layer, and is cooperated with the thermal activation delay fluorescent material of the organic light-emitting layer, thereby improving the current efficiency and service life of the organic light-emitting display.

### BRIEF DESCRIPTION OF THE DRAWINGS

FIG. 1 is a schematic diagram illustrating an organic light-emitting display according to one preferred embodiment of the present disclosure.
FIG. 2 is a schematic diagram illustrating an organic light-emitting display according to Comparative Example 1.

### DETAILED DESCRIPTION

In order to make the purpose, technical solutions and advantages of the present disclosure to be understood more clearly, the present disclosure will be described in further details with the accompanying drawings and the following embodiments. It should be understood that the specific embodiments described herein are merely examples to illustrate the present invention, not to limit the present disclosure.

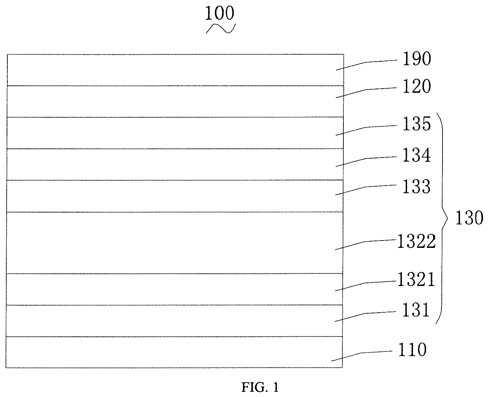

Referring to FIG. 1, an organic light-emitting display 100 includes a first electrode 110, a second electrode 120, and a functional structure layer 130 located between the first electrode 110 and the second electrode 120.

In this embodiment, the first electrode 110 may be an indium tin oxide electrode, and the second electrode 120 may be a silver electrode. Certainly, the first electrode 110 and the second electrode 120 are not limited to the above-mentioned electrodes, but can be other electrodes.

In this embodiment, the organic light-emitting display 100 may be a top emitting organic light-emitting display. For optimal performance, a circular polarizer layer 190 is further disposed on one side of the second electrode 120 far away from the functional structure layer 130. Certainly, the circular polarizer layer 190 may not be disposed.

The functional structure layer 130 includes a hole injection layer 131, a first hole transport layer 1321, a second hole transport layer 1322, an organic light-emitting layer 133, an electron transport layer 134, and an electron injection layer 135 which are sequentially laminated on the first electrode 110.

Materials and thicknesses of the hole injection layer 131, the electron transport layer 134, and the electron injection layer 135 are well known to those skilled in the art and will not be repeated here.

In the present disclosure, the main function of the first hole transport layer 1321 is to transport holes. The second hole transport layer 1322 also serves as an electron blocking layer and an optical compensation layer apart from a hole transport layer.

A triplet state energy level of a material of the second hole transport layer 1322 is greater than 2.5eV. A highest occupied orbital energy level of the material of the second hole transport layer 1322 is greater than a highest occupied orbital energy level of a material of the first hole transport layer 1321.

Preferably, the material of the first hole transport layer 1321 may be selected from NPB. Certainly, the material of the first hole transport layer 1321 is not limited to NPB and can be other hole transporting materials.

Preferably, a thickness of the first hole transport layer 1321 may be 1-40nm, more preferably 5-20nm.

The material of the second hole transport layer is selected from a compound represented by structural formula (1) below 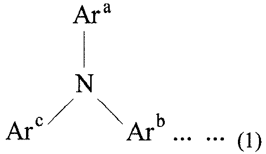
-Ar^{a} is represented by a structural formula (1-1) or (1-2) below, - L^{a} -(-Ar^{d})ₙ ......₍₁₋₁₎ 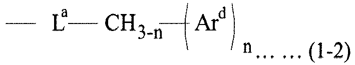 where -L^{a} is selected from aromatic ring containing 6 to 25 ring carbon atoms, or aromatic heterocyclic ring containing 5 to 25 ring atoms, -Ar^{d} is selected from aryl group containing 6 to 25 ring carbon atoms, or heteroaryl group containing 5 to 25 ring atoms, n is selected from 2 or 3, and a plurality of-Ar^{d} are same or different.
-Ar^{b} is represented by a structural formula (1-3) below 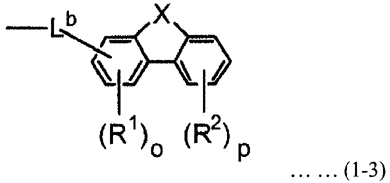 where -L^{b} is selected from substituted or unsubstituted arylene containing 6 to 25 ring carbon atoms, or substituted or unsubstituted heteroarylene containing 5 to 25 ring atoms, and L^{b} is connected to a ring connecting with R¹ by a single bond.

R¹ and R² are each independently selected from an alkyl group containing 1 to 15 carbon atoms, alkenyl group containing 2 to 15 carbon atoms, naphthenic group containing 3 to 15 ring carbon atoms, aryl group containing 6 to 25 ring carbon atoms, heteroaryl group containing 5 to 25 ring atoms, trialkylsilyl group formed by alkyl groups each containing 1 to 15 carbon atoms, triarylsilyl group formed by aryl groups each containing 6 to 25 ring carbon atoms, alkylarylsilyl group formed by alkyl group containing 1 to 15 carbon atoms and aryl group containing 6 to 25 ring carbon atoms, carbazolyl group, halogen atom, or cyano group. o is selected from an integer of 0 to 3. p is selected from an integer of 0 to 4. A plurality of R¹ adjacent to each other are bondable to each other to form a ring, a plurality of R² adjacent to each other are bondable to each other to form a ring, and R¹ and R² are bondable to each other to form a ring. X is selected from CR³R⁴, NR⁵, O and S. R³, R⁴, and R⁵ is each independently selected from substituted or unsubstituted alkyl group containing 1 to 15 carbon atoms, or substituted or unsubstituted aryl group containing 6 to 25 ring carbon atoms.

Ar^{c} is selected from substituted or unsubstituted aryl group containing 6 to 50 ring carbon atoms or substituted or unsubstituted heteroaryl group containing 5 to 25 ring atoms, or a structure represented by the structural formula (1-1), (1-2), or (1-3).

The material of the second hole transport layer 1322 may be preferably selected from compounds represented by following structural fonnulas:

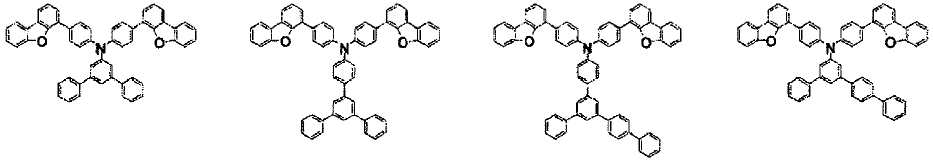

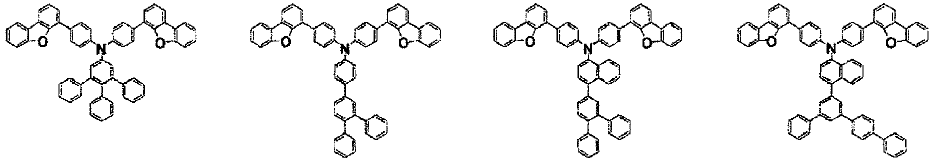

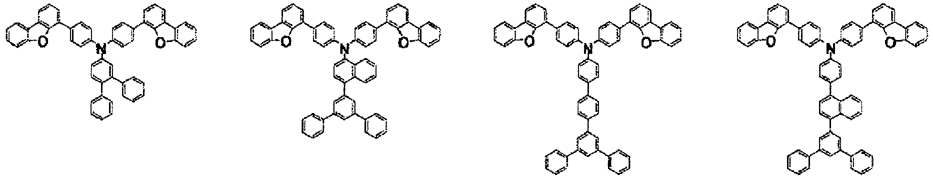

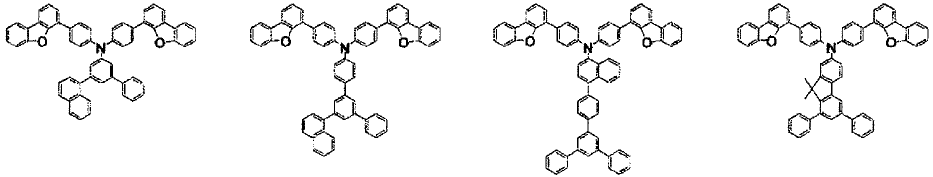

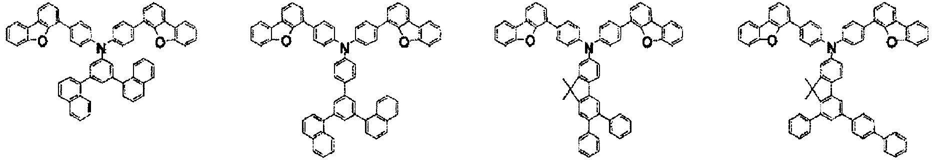

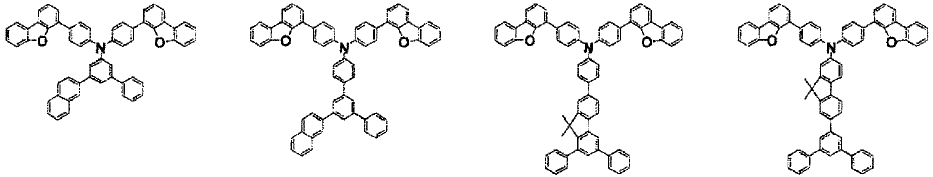

A thickness of the second hole transport layer 1322 is 20-50nm, preferably 35-45nm.

The organic light-emitting layer 133 includes a light emitting host material. The light emitting host material is a thermal activation delay fluorescent material.

In the present disclosure, the organic light-emitting display may be preferably a green light device, that is, the light emitting host material is a green light thermal activation delay fluorescent material.

Preferably, the light emitting host material may be selected from a compound represented by structural formula (2) below: 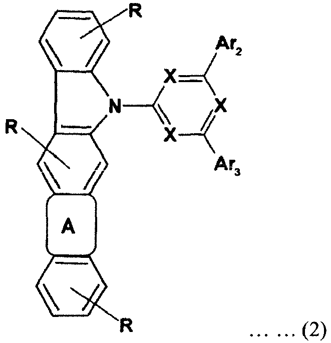 where a ring A is represented by a structural formula (2-1) below:

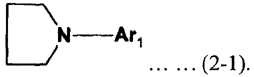

The ring A and a ring adjacent to the ring A may form a condensed ring. X may be selected from N or CH, wherein at least one X is selected from N. Ar₁, Ar₂, and Ar₃ may be each independently selected from substituted or unsubstituted non-condensed ring aryl hydrocarbon substituent, and substituted or unsubstituted non-condensed ring aryl heterocyclic substituent, and it is not ruled out that Ar₂ and Ar₃ may form a condensed ring structure through an aromatic ring containing heteroatom. R may be selected from H atom and monovalent substituent.

More preferably, the light emitting host material may be selected from compounds represented by the following structural formulas (3-1), (3-2) and (3-3): 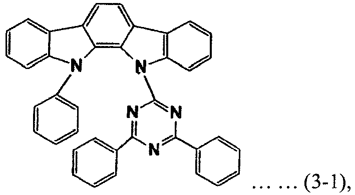 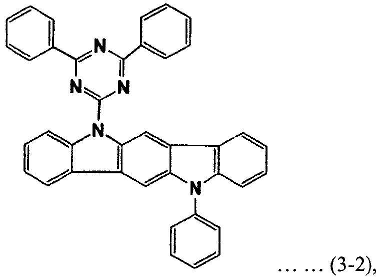 and

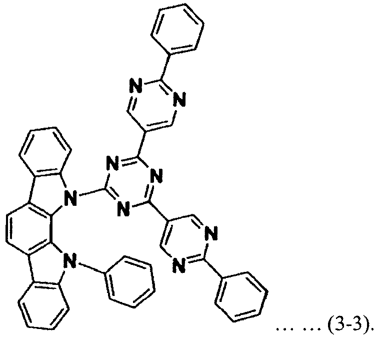

Certainly, the light emitting host material is not limited to the above-mentioned compounds represented by the above-mentioned structural formulas, but can be compounds represented by the following structural formulas:

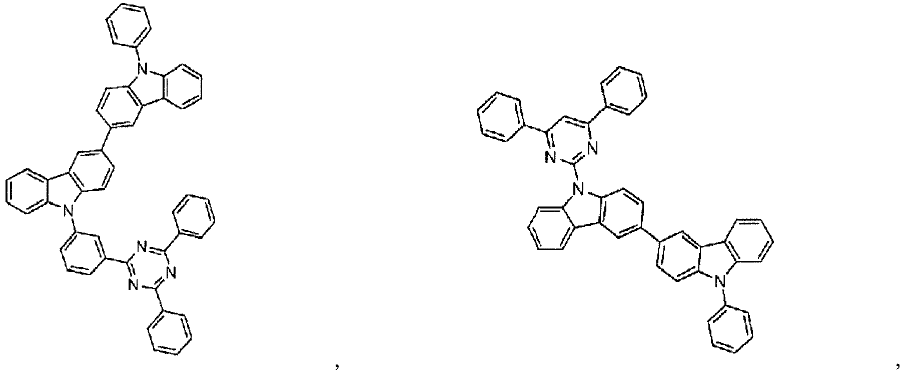

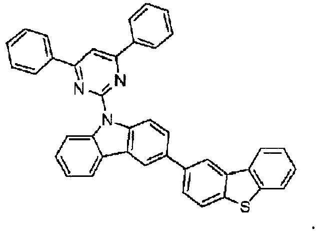

In practical use, the organic light-emitting layer 133 may generally further include a coloring matter. The coloring matter may be selected from coloring matters known to those skilled in the art.

Preferably, a thickness of the organic light-emitting layer may be 10-40nm.

Certainly, the organic light-emitting display is not limited to the green light device, but can be a red light device or a blue light device.

The organic light-emitting display adopts two hole transport layers, wherein the second hole transport layer acts as both an electron blocking layer and an optical compensation layer, and is cooperated with the thermal activation delay fluorescent material of the organic light-emitting layer, thereby improving the current efficiency and service life of the organic light-emitting display. Furthermore, the process difficult is not increased compared with the prior art.

A display device is further provided in the present disclosure. The display device may include the organic light-emitting display described in the present disclosure.

The present disclosure will be further described with reference to the following exemplary embodiments.

### Example One

As shown in FIG. 1, a top emitting green light single host device may include a first electrode 110, a hole injection layer 131, a first hole transport layer 1321, a second hole transport layer 1322, an organic light-emitting layer 133, an electron transport layer 134, an electron injection layer 135, a second electrode 120, and a circular polarizer layer 190 which are sequentially arranged from bottom to top.

The first electrode 110 may be an indium tin oxide electrode with a thickness of 40nm.

The hole injection layer 131 may be made of HAT with a thickness of lOnm.

The first hole transport layer 1321 may be made of NPB with a thickness of 20nm.

The second hole transport layer 1322 may be made of a material represented by the following structural formula, with a thickness of 40 nm:

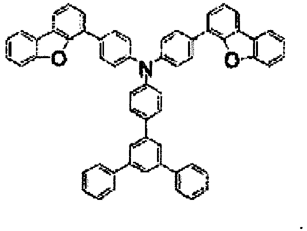

The organic light-emitting layer 133 may be made of a material represented by the following structural formula, with a thickness of 30nm:

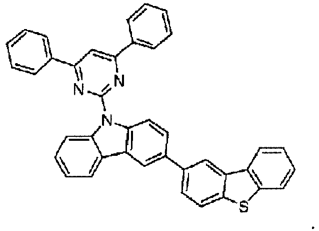

The electron transport layer 134 may be a co-evaporation layer of Bphen and Liq with a thickness of 30nm.

The electron injection layer 135 may be made of magnesium silver alloy with a thickness of 2nm.

The second electrode 120 may be a silver electrode with a thickness of 16nm.

The circular polarizer layer 190 may be made of Alq₃ with a thickness of 65nm.

### Comparative Example 1

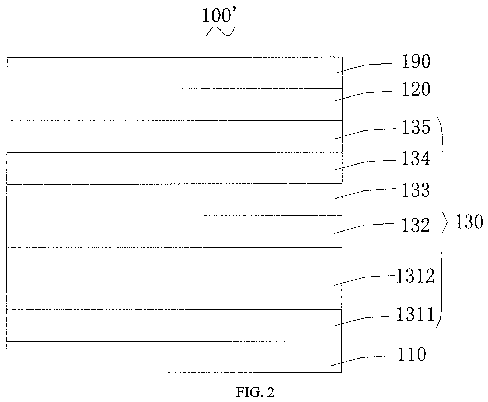

Referring to FIG. 2, Comparative Example 1 is substantially same as Example 1, except that the top emitting green light single host OLED 100' only include one hole transport layer 132. The hole transport layer 132 is made of the same material as the second hole transport layer 1322 of Example 1.

There are two hole injection layers, i.e., a first hole injection layer 1311 and a second hole injection layer 1312, wherein the second hole injection layer may act as an optical compensation layer with a thickness of 35nm. The second hole injection layer may be made of 4,4,4-tri(N-3-methyl phenyl-N-phenyl-amino)-triphenylamine (m-MTDATA).

### Comparative Example 2

Comparative Example 2 is substantially same as Comparative Example 1, except that the hole transport layer is made of NPB.

### Performance Test

### CIE-x Test and CIE-y test:

Chromatic value test is carried out at 1931 CIE with a PR705 spectrograph.

### Service life test:

Service life decay test is carried out at an initial luminance of 10 Knit with a service life tester, to calculate a time the luminance is decayed to 97% of the initial luminance.

Voltages, current efficiencies, CIE-x, CIE-y, and service lives of the OLED of Example 1 and Comparative Examples 1-2 are respectively tested and listed in Table 1.

**Table 1**

| Device | Voltage V | Current Efficiency (cd/A) | CIE-x | CIE-y | Service life (T97@10Knit) h |
|---|---|---|---|---|---|
| Example 1 | 4.42 | 97.59 | 0.2377 | 0.7210 | 335 |
| Comparative Example 1 | 4.68 | 92.53 | 0.2014 | 0.7341 | 170 |
| Comparative Example 2 | 4.32 | 87.74 | 0.2168 | 0.7243 | 110 |

It can be seen from Table 1 that compared with Comparative Examples 1 or 2, the current efficiency, CIE-x, CIE-y, and the service life of the device of Example 1 is greatly increased. Compared with Comparative Example 2, the current efficiency of the device of Example 1 is increased by 11.2%, and the service life of the device of Example 1 is increased by 225 hours which is nearly triple of the service life in Comparative Example 2. Compared with Comparative Example 1, the current efficiency of the device of Example 1 is increased by 10%, and the service life of the OLED of Example 1 is increased by 165 hours which is nearly double of the service life in Comparative Example 1.

Technical features of the above embodiments may be combined arbitrarily. For brief description, not all of the possible combinations of the technical features of the above embodiments are described, but it will be appreciated that these possible combinations belong to the scope of the present disclosure once there is no conflict between the technical features.

The above are embodiments of the disclosure described in detail, and should not be deemed as limitations to the scope of the present disclosure. It should be noted that variations and improvements will become apparent to those skilled in the art to which the present disclosure pertains without departing from its scope. Therefore, the scope of the present disclosure is defined by the appended claims.

## Claims

1. An organic light-emitting display, comprising:
a first electrode;
a second electrode; and
a functional structure layer, located between the first electrode and the second electrode, wherein the functional structure layer includes a hole injection layer, a first hole transport layer, a second hole transport layer, an organic light-emitting layer, an electron transport layer, and an electron injection layer which are sequentially laminated on the first electrode,
wherein a highest occupied orbital energy level of a first material forming the first hole transport layer is less than a highest occupied orbital energy level of a second material forming the second hole transport layer, a triplet state energy level of the second material is greater than 2.5 eV,
the organic light-emitting layer includes a light emitting host material, and the light emitting host material includes a thermal activation delay fluorescent material,
wherein the second material forming the second hole transport layer is selected from a compound represented by a structural formula (1) below: 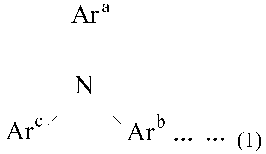 wherein
-Ar^{a} is represented by a structural formula (1-1) or (1-2) below,
- L^{a} -(-Ar^{d})ₙ...... ₍₁₋₁₎ 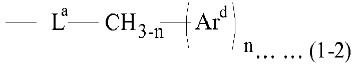
where -L^{a} is selected from aromatic ring containing 6 to 25 ring carbon atoms, or aromatic heterocyclic ring containing 5 to 25 ring atoms, -Ar^{d} is selected from aryl group containing 6 to 25 ring carbon atoms, or heteroaryl group containing 5 to 25 ring atoms, n is selected from 2 or 3, and a plurality of -Ar^{d} are same or different;
-Ar^{b} is represented by a structural formula (1-3) below: 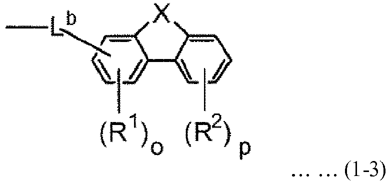
where -L^{b} is selected from arylene group containing 6 to 25 ring carbon atoms, or heteroarylene group containing 5 to 25 ring atoms, L^{b} is connected by a single bond to a ring connecting with R¹,
R¹ and R² are each independently selected from alkyl group containing 1 to 15 carbon atoms, alkenyl group containing 2 to 15 carbon atoms, naphthenic group containing 3 to 15 ring carbon atoms, aryl group containing 6 to 25 ring carbon atoms, heteroaryl group containing 5 to 25 ring atoms, trialkylsilyl group formed by alkyl groups each containing 1 to 15 carbon atoms, a triarylsilyl group formed by aryl groups each containing 6 to 25 ring carbon atoms, alkylarylsilyl group formed by an alkyl group containing 1 to 15 carbon atoms and an aryl group containing 6 to 25 ring carbon atoms, carbazolyl group, halogen atom, or cyano group; o is selected from an integer of 0 to 3; p is selected from an integer of 0 to 4; a plurality of R¹ adjacent to each other are bondable to each other to form a ring, a plurality of R² adjacent to each other are bondable to each other to form a ring, R¹ and R² are bondable to each other to form a ring; X is selected from CR³R⁴, NR⁵, O or S; and R³, R⁴ and R⁵ each is independently selected from an alkyl group containing 1 to 15 carbon atoms, or an aryl group containing 6 to 25 ring carbon atoms; and
Ar^{c} is selected from an aryl group containing 6 to 50 ring carbon atoms or a heteroaryl group containing 5 to 25 ring atoms, or a structure represented by the structural formula (1-1), (1-2), or (1-3),
wherein the second hole transport layer has a thickness of 20-50 nm.

2. The organic light-emitting display of claim 1, wherein the second hole transport layer has a thickness of 35-45 nm.

3. The organic light-emitting display of claim 1, wherein the light emitting host material includes a green light thermal activation delay fluorescent material.

4. The organic light-emitting display of claim 3, wherein the light emitting host material is selected from a compound represented by a structural formula (2) below: 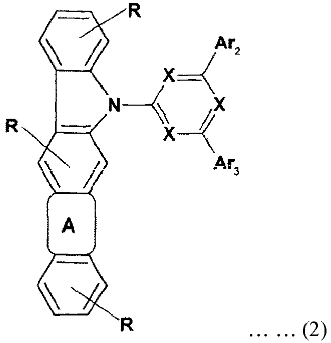 wherein
a ring A is represented by a structural formula (2-1) below 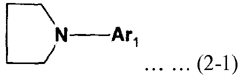 the ring A is fused to a ring adjacent thereto to form a condensed ring; X is selected from N or CH, and at least one X is selected from N; Ar₁, Ar₂, and Ar₃ are each independently selected from non-condensed ring aryl hydrocarbon substituent, or non-condensed ring aryl heterocyclic substituent, and it is not ruled out that Ar₂ and Ar₃ form a condensed ring structure through an aromatic ring containing a heteroatom; and R is selected from H atom or monovalent substituent.

5. The organic light-emitting display of claim 4, wherein the light emitting host material is selected from one of compounds represented by the following structural formulas (3-1), (3-2) and (3-3) respectively: 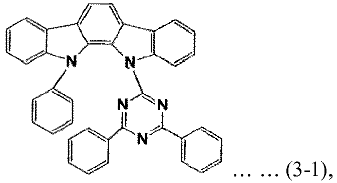 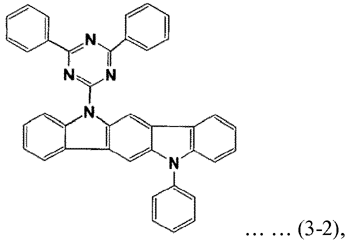 and

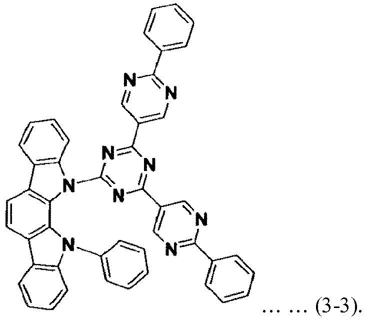

6. The organic light-emitting display of claim 1, wherein the light emitting host material includes a red light thermal activation delay fluorescent material.

7. The organic light-emitting display of any one of claims 1-6, wherein the first hole transport layer has a thickness of 1-40 nm.

8. The organic light-emitting display of any one of claims 1-6, wherein a circular polarizer layer is further disposed on one side of the second electrode far away from the functional structure layer.

9. The organic light-emitting display of any one of claims 1-6, wherein the organic light-emitting layer has a thickness of 10-40 nm.

10. The organic light-emitting display of claim 7, wherein first hole transport layer has a thickness of 5-20 nm.

11. The organic light-emitting display of any one of claims 1-6, wherein the second hole transport layer is made of aryl tertiary amine compound

12. The organic light-emitting display of any one of claims 1-6, wherein the organic light-emitting layer includes a coloring matter.

13. A display device, comprising the organic light-emitting display of any one of claims 1-6.

## Patentansprüche

1. Organische lichtemittierende Anzeige, die Folgendes umfasst:
eine erste Elektrode;
eine zweite Elektrode; und
eine funktionale Strukturschicht, die sich zwischen der ersten Elektrode und der zweiten Elektrode befindet, wobei die funktionale Strukturschicht eine Lochinjektionsschicht, eine erste Lochtransportschicht, eine zweite Lochtransportschicht, eine organische lichtemittierende Schicht, eine Elektronentransportschicht und eine Elektroneninjektionsschicht enthält, die nacheinander auf die erste Elektrode laminiert sind,
wobei ein höchstes besetztes Orbitalenergieniveau eines ersten Materials, das die erste Lochtransportschicht bildet, geringer ist als ein höchstes besetztes Orbitalenergieniveau eines zweiten Materials, das die zweite Lochtransportschicht bildet, wobei ein Triplettzustandsenergieniveau des zweiten Materials größer als 2,5 eV ist,
wobei die organische lichtemittierende Schicht ein lichtemittierendes Wirtsmaterial enthält und das lichtemittierende Wirtsmaterial ein thermisch aktiviertes verzögertes Fluoreszenzmaterial enthält;
wobei das zweite Material, das die zweite Lochtransportschicht bildet, ausgewählt ist aus einer Verbindung, die durch die unten folgende Strukturformel (1) dargestellt wird: 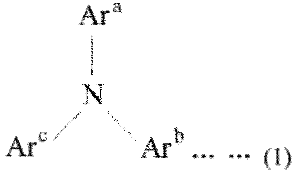 wobei
-Ar^{a} durch eine unten folgende Strukturformel (1-1) oder (1-2) dargestellt wird,
- L^{a} -(-Ar^{d})_{n... ...} ₍₁₋₁₎ 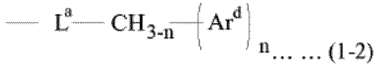
wobei -L^{a} ausgewählt ist aus einem aromatischen Ring, der 6 bis 25 Ringkohlenstoffatome enthält, oder einem aromatischen heterozyklischen Ring, der 5 bis 25 Ringatome enthält, -Ar^{d} ausgewählt ist aus einer Arylgruppe, die 6 bis 25 Ringkohlenstoffatome enthält, oder einer Heteroarylgruppe, die enthält 5 bis 25 Ringatome enthält, wobei n ausgewählt ist aus 2 oder 3, und eine Vielzahl von -Ar^{d} gleich oder verschieden ist;
-Ar^{b} durch eine unten folgende Strukturformel (1-3) dargestellt wird: 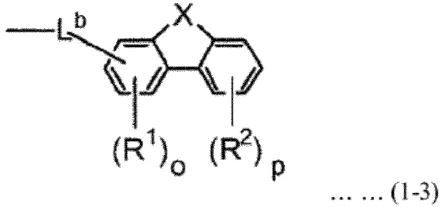
wobei -L^{b} ausgewählt ist aus einer Arylengruppe, die 6 bis 25 Ringkohlenstoffatome enthält, oder einer Heteroarylengruppe, die 5 bis 25 Ringatome enthält, wobei L^{b} durch eine Einfachbindung mit einem Ring verbunden ist, der mit R¹ verbunden ist.
wobei R¹ und R² jeweils unabhängig voneinander ausgewählt sind aus einer Alkylgruppe, die 1 bis 15 Kohlenstoffatome enthält, einer Alkenylgruppe, die 2 bis 15 Kohlenstoffatome enthält, einer Naphthengruppe, die 3 bis 15 Ringkohlenstoffatome enthält, einer Arylgruppe, die 6 bis 25 Ringkohlenstoffatome enthält, einer Heteroarylgruppe, die 5 bis 25 Ringatome enthält, einer Trialkylsilylgruppe, die durch Alkylgruppen gebildet ist, die jeweils 1 bis 15 Kohlenstoffatome enthalten, einer Triarylsilylgruppe, die durch Arylgruppen gebildet ist, die jeweils 6 bis 25 Ringkohlenstoffatome enthalten, einer Alkylarylsilylgruppe, die durch eine Alkylgruppe, die 1 bis 15 Kohlenstoffatome enthält, und einer Arylgruppe, die 6 bis 25 Ringkohlenstoffatome enthält, gebildet ist, einer Carbazolylgruppe, einem Halogenatom oder einer Cyanogruppe; wobei o aus einer ganzen Zahl von 0 bis 3 ausgewählt wird; p aus einer ganzen Zahl von 0 bis 4 ausgewählt wird; eine Vielzahl von benachbarten R¹ miteinander verbunden sein können, um einen Ring zu bilden, eine Vielzahl von benachbarten R² miteinander verbunden sein können, um einen Ring zu bilden, und R¹ und R² miteinander verbunden sein können, um einen Ring zu bilden; wobei X ausgewählt ist aus CR³R⁴, NR⁵, O oder S; und R³, R⁴ und R⁵ jeweils unabhängig ausgewählt sind aus einer Alkylgruppe, die 1 bis 15 Kohlenstoffatome enthält, oder einer Arylgruppe, die 6 bis 25 Ringkohlenstoffatome enthält; und
wobei Ar^{c} ausgewählt ist aus einer Arylgruppe, die 6 bis 50 Ringkohlenstoffatome enthält, oder einer Heteroarylgruppe, die 5 bis 25 Ringatome enthält, oder einer Struktur, die durch die Strukturformel (1-1), (1-2) oder (1-3) dargestellt wird,
wobei die zweite Lochtransportschicht eine Dicke von 20 bis 50 nm aufweist.

2. Organische lichtemittierende Anzeige nach Anspruch 1, wobei die zweite Lochtransportschicht eine Dicke von 35 bis 45 nm aufweist.

3. Organische lichtemittierende Anzeige nach Anspruch 1, wobei das lichtemittierende Wirtsmaterial ein Grünlicht emittierendes, thermisch aktiviertes verzögertes Fluoreszenzmaterial enthält.

4. Organische lichtemittierende Anzeige nach Anspruch 3, wobei das lichtemittierende Wirtsmaterial ausgewählt ist aus einer Verbindung, die durch die unten folgende Strukturformel (2) dargestellt wird: 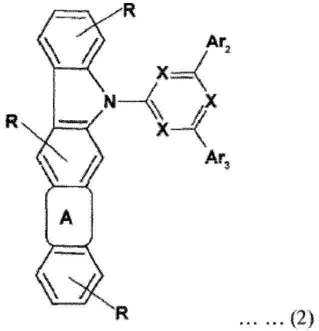 wobei
ein Ring A durch eine unten folgende Strukturformel (2-1) dargestellt wird: 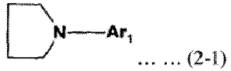 wobei der Ring A mit einem benachbarten Ring verschmolzen ist, um einen kondensierten Ring zu bilden; X aus N oder CH ausgewählt ist, und mindestens ein X aus N ausgewählt ist; Ar₁, Ar₂, und Ar₃ jeweils unabhängig voneinander aus einem nicht kondensierten Ring-Arylkohlenwasserstoff-Substituenten oder einem nicht kondensierten Ring-Aryl-heterozyklischen Substituenten ausgewählt sind, und wobei es nicht ausgeschlossen ist, dass Ar₂ und Ar₃ durch einen aromatischen Ring, der ein Heteroatom enthält, eine kondensierte Ringstruktur bilden; und wobei R aus einem H-Atom oder einem einwertigen Substituenten ausgewählt ist.

5. Organische lichtemittierende Anzeige nach Anspruch 4, wobei das lichtemittierende Wirtsmaterial ausgewählt ist aus einer der Verbindungen, die jeweils durch die folgenden Strukturformeln (3-1), (3-2) und (3-3) dargestellt sind: 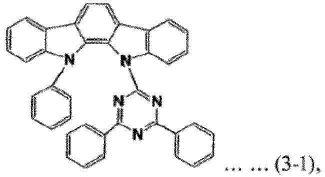 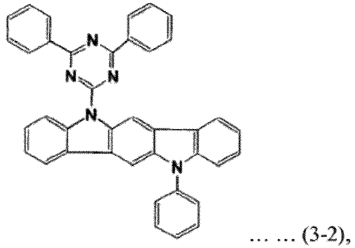 und

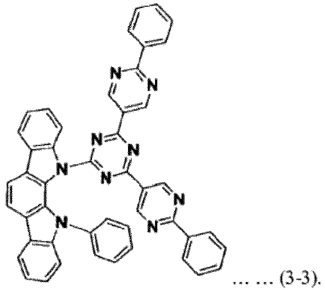

6. Organische lichtemittierende Anzeige nach Anspruch 1, wobei das lichtemittierende Wirtsmaterial ein Rotlicht emittierendes, thermisch aktiviertes verzögertes fluoreszenzmaterial enthält.

7. Organische lichtemittierende Anzeige nach einem der Ansprüche 1 bis 6, wobei die erste Lochtransportschicht eine Dicke von 1 bis 40 nm aufweist.

8. Organische lichtemittierende Anzeige nach einem der Ansprüche 1 bis 6, wobei weiterhin eine kreisförmige Polarisatorschicht auf einer Seite der zweiten Elektrode weit weg von der funktionalen Strukturschicht angeordnet ist.

9. Organische lichtemittierende Anzeige nach einem der Ansprüche 1 bis 6, wobei die organische lichtemittierende Schicht eine Dicke von 10 bis 40 nm aufweist.

10. Organische lichtemittierende Anzeige nach Anspruch 7, wobei die erste Lochtransportschicht eine Dicke von 5 bis 20 nm aufweist.

11. Organische lichtemittierende Anzeige nach einem der Ansprüche 1 bis 6, wobei die zweite Lochtransportschicht aus einer tertiären Arylaminverbindung besteht.

12. Organische lichtemittierende Anzeige nach einem der Ansprüche 1 bis 6, wobei die organische lichtemittierende Schicht ein Färbemittel enthält.

13. Anzeigevorrichtung, die die organische lichtemittierende Anzeige nach einem der Ansprüche 1 bis 6 umfasst.

## Revendications

1. Dispositif d'affichage électroluminescent organique, comprenant :
une première électrode,
une deuxième électrode, et
une couche de structure fonctionnelle, située entre la première électrode et la deuxième électrode, ladite couche de structure fonctionnelle comportant une couche d'injection de trous, une première couche de transport de trous, une deuxième couche de transport de trous, une couche électroluminescente organique, une couche de transport d'électrons et une couche d'injection d'électrons successives formant un stratifié sur la première électrode ; étant entendu que
le niveau d'énergie orbital occupé le plus élevé d'un premier matériau formant la première couche de transport de trous est inférieur au niveau d'énergie orbital occupé le plus élevé d'un deuxième matériau formant la deuxième couche de transport de trous, et un niveau d'énergie d'état triplet du deuxième matériau est supérieur à 2,5 eV,
la couche électroluminescente organique comporte un matériau hôte électroluminescent, et le matériau hôte électroluminescent comporte un matériau à fluorescence retardée activé par voie thermique,
le deuxième matériau formant la deuxième couche de transport de trous est choisi à partir d'un composé représenté par une formule structurelle (1) ci-dessous : 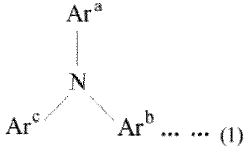 dans laquelle
-Ar^{a} est représenté par une formule structurelle (1-1) ou (1-2) ci-dessous,
-L^{a}-(-Ar^{d})_{n... ...} ₍₁₋₁₎ 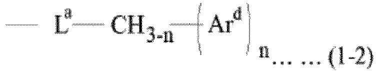
dans laquelle -L^{a} est choisi parmi un cycle aromatique contenant 6 à 25 atomes de carbone cycliques et un cycle hétérocyclique aromatique contenant 5 à 25 atomes cycliques, -Ar^{d} est choisi parmi un groupe aryle contenant 6 à 25 atomes de carbone cycliques et un groupe hétéroaryle contenant 5 à 25 atomes cycliques, n vaut 2 ou 3, et une pluralité de -Ar^{d} sont identiques ou différents ;
-Ar^{b} est représenté par une formule structurelle (1-3) ci-dessous : 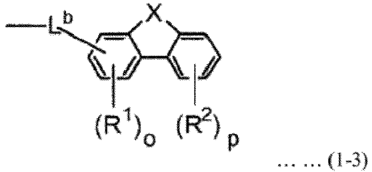
dans laquelle -L^{b} est choisi parmi un groupe arylène contenant 6 à 25 atomes de carbone cycliques et un groupe hétéroarylène contenant 5 à 25 atomes cycliques, L^{b} est relié par une liaison simple à un cycle se liant à R¹,
R¹ et R² sont chacun choisis indépendamment parmi un groupe alkyle contenant 1 à 15 atomes de carbone, un groupe alcényle contenant 2 à 15 atomes de carbone, un groupe naphténique contenant 3 à 15 atomes de carbone cycliques, un groupe aryle contenant 6 à 25 atomes de carbone cycliques, un groupe hétéroaryle contenant 5 à 25 atomes cycliques, un groupe trialkylsilyle constitué par des groupes alkyle contenant chacun 1 à 15 atomes de carbone, un groupe triarylsilyle constitué par des groupes aryle contenant chacun 6 à 25 atomes de carbone cycliques, un groupe alkylarylsilyle constitué par un groupe alkyle contenant 1 à 15 atomes de carbone et un groupe aryle contenant 6 à 25 atomes de carbone cycliques, un groupe carbazolyle, un atome d'halogène ou un groupe cyano ; o est choisi parmi un nombre entier allant de 0 à 3 ; p est choisi parmi un nombre entier allant de 0 à 4 ; une pluralité de R¹ adjacents entre eux peuvent être liés entre eux pour former un cycle, une pluralité de R² adjacents entre eux peuvent être liés entre eux pour former un cycle, R¹ et R² peuvent être liés entre eux pour former un cycle ; X est choisi parmi CR³R⁴, NR⁵, O et S ; et R³, R⁴ et R⁵ sont chacun indépendamment choisis parmi un groupe alkyle contenant 1 à 15 atomes de carbone et un groupe aryle contenant 6 à 25 atomes de carbone cycliques ; et
Ar^{c} est choisi parmi un groupe aryle contenant 6 à 50 atomes de carbone cycliques, un groupe hétéroaryle contenant 5 à 25 atomes cycliques et une structure représentée par la formule structurelle (1-1), (1-2) ou (1-3),
la deuxième couche de transport de trous a une épaisseur de 20à 50 nm.

2. Dispositif d'affichage électroluminescent organique selon la revendication 1, dans lequel la deuxième couche de transport de trous a une épaisseur de 35à 45 nm.

3. Dispositif d'affichage électroluminescent organique selon la revendication 1, dans lequel le matériau hôte électroluminescent comporte un matériau à fluorescence retardée activé par voie thermique à lumière verte.

4. Dispositif d'affichage électroluminescent organique selon la revendication 3, dans lequel le matériau hôte électroluminescent est choisi à partir d'un composé représenté par une formule structurelle (2) ci-dessous : 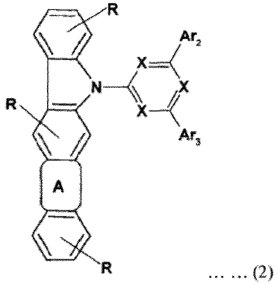 dans laquelle
un cycle A est représenté par une formule structurelle (2-1) ci-dessous 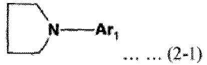 le cycle A est fusionné à un cycle adjacent à celui-ci pour former un cycle condensé ; X est choisi parmi N et CH, et au moins un X est choisi à partir de N ; Ar₁, Ar₂ et Ar₃ sont chacun choisis indépendamment parmi un substituant hydrocarboné aryle cyclique non condensé et un substituant hétérocyclique aryle cyclique non condensé, sans exclure qu'Ar₂ et Ar₃ forment une structure cyclique condensée par l'intermédiaire d'un cycle aromatique contenant un hétéroatome ; et R est choisi parmi un atome de H et un substituant monovalent.

5. Dispositif d'affichage électroluminescent organique selon la revendication 4, dans lequel le matériau hôte électroluminescent est choisi parmi un des composés représentés par les formules structurelles (3-1), (3-2) et (3-3) respectives suivantes : 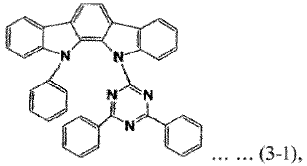 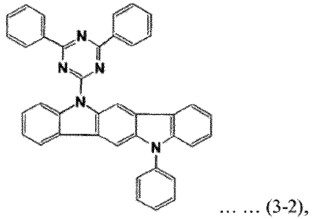 et

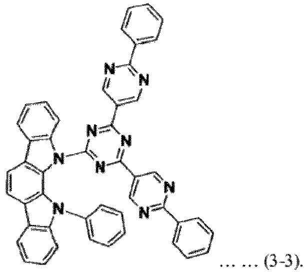

6. Dispositif d'affichage électroluminescent organique selon la revendication 1, dans lequel le matériau hôte électroluminescent comporte un matériau à fluorescence retardée activé par voie thermique à lumière rouge.

7. Dispositif d'affichage électroluminescent organique selon l'une quelconque des revendications 1 à 6, dans lequel la première couche de transport de trous a une épaisseur de 1 à 40 nm.

8. Dispositif d'affichage électroluminescent organique selon l'une quelconque des revendications 1 à 6, dans lequel une couche de polarisation circulaire est encore disposée sur un côté de la deuxième électrode qui est éloigné de la couche de structure fonctionnelle.

9. Dispositif d'affichage électroluminescent organique selon l'une quelconque des revendications 1 à 6, dans lequel la couche électroluminescente organique a une épaisseur de 10 à 40 nm.

10. Dispositif d'affichage électroluminescent organique selon la revendication 7, dans lequel la première couche de transport de trous a une épaisseur de 5 à 20 nm.

11. Dispositif d'affichage électroluminescent organique selon l'une quelconque des revendications 1 à 6, dans lequel la deuxième couche de transport de trous est réalisée dans un composé à base d'aminé tertiaire d'aryle.

12. Dispositif d'affichage électroluminescent organique selon l'une quelconque des revendications 1 à 6, dans lequel la couche électroluminescente organique comporte une matière colorante.

13. Appareil d'affichage, comprenant le dispositif d'affichage électroluminescent organique selon l'une quelconque des revendications 1 à 6.
